# EUROPEAN PATENT APPLICATION

(11) **EP 4 657 778 A1**
(43) Date of publication of application: **03.12.2025**
(21) Application number: 23922400.9
(22) Date of filing: 14.11.2023
(51) Int. Cl.: H04L 1/00

(54) **PHYSICAL LAYER DATA TRANSMISSION METHOD AND APPARATUS, SYSTEM, DEVICE, AND CHIP**

(30) Priority: 13.02.2023 CN 202310138237
(71) Applicant: Huawei Technologies Co., Ltd., Shenzhen, Guangdong 518129 (CN)
(72) Inventor: MU, Tong, Shenzhen, Guangdong 518129 (CN); LI, Ying, Shenzhen, Guangdong 518129 (CN); YANG, Yumeng, Shenzhen, Guangdong 518129 (CN); ZHUANG, Yan, Shenzhen, Guangdong 518129 (CN)
(74) Representative: Isarpatent
(86) International application number: PCT/CN2023/131636
(87) International publication number: WO 2024/169284

(57) **Abstract**

This application discloses a physical layer data transmission method, apparatus, system, and device, and a chip, and belongs to the field of communication technologies. In the method, after obtaining first data, a first device processes the first data based on a current operation mode, to obtain second data. The current operation mode indicates whether to perform FEC bypass, and the current operation mode is determined based on capabilities of the first device and a second device. Then, the first device sends the second data to the second device. According to the method provided in this application, in a physical layer data transmission process, whether to perform FEC bypass may be properly determined based on the current operation mode. In this way, a requirement of using FEC in a long-distance data transmission scenario can be supported, and a requirement of not using FEC in a low-latency data transmission scenario can also be supported, ensuring reliability of data transmission in different scenarios.

## Description

This application claims priority to Chinese Patent Application No. 202310138237.5, filed with the China National Intellectual Property Administration on February 13, 2023 and entitled "PHYSICAL LAYER DATA TRANSMISSION METHOD, APPARATUS, SYSTEM, AND DEVICE, AND CHIP", which is incorporated herein by reference in its entirety.

### TECHNICAL FIELD

This application relates to the field of communication technologies, and in particular, to a physical layer data transmission method, apparatus, system, and device, and a chip.

### BACKGROUND

In the field of communication technologies, forward error correction (forward error correction, FEC) is used to improve reliability of data transmission. How to properly use FEC in a physical layer data transmission process becomes an urgent problem to be resolved.

### SUMMARY

This application provides a physical layer data transmission method, apparatus, system, and device, and a chip, to properly use FEC in a physical layer data transmission process. Technical solutions provided in this application include the following aspects.

According to a first aspect, a physical layer data transmission method is provided. In the method, after obtaining first data, a first device processes the first data based on a current operation mode, to obtain second data. The current operation mode indicates whether to perform FEC bypass, and the current operation mode is determined based on capabilities of the first device and a second device. Then, the first device sends the second data to the second device.

Because the current operation mode is determined based on a capability of the first device and a capability of the second device, regardless of an indication of the current operation mode, the indication can be supported by the capability of the first device and the capability of the second device. Because the current operation mode indicates whether to perform FEC bypass, the first device and the second device may properly determine, based on the current operation mode, whether FEC needs to be used.

For example, the first device and the second device may not perform FEC bypass in a long-distance data transmission scenario, that is, use FEC, to increase a signal-to-noise ratio (signal-to-noise ratio, SNR) margin in a data transmission process. For another example, the first device and the second device may perform FEC bypass in a low-latency data transmission scenario, that is, FEC is not used, to reduce a physical layer latency in a data transmission process. Therefore, the method provided in this application can support both the long-distance data transmission scenario and the low-latency data transmission scenario, to ensure reliability of data transmission in different scenarios.

In a possible implementation, that the first device sends the second data to the second device includes: The first device sends the second data to the second device via a single pair Ethernet (single pair Ethernet, SPE). The SPE can support a high bandwidth, can take into account a long transmission distance, and has strong applicability.

In a possible implementation, that the first device processes the first data based on the current operation mode, to obtain the second data includes: When the current operation mode indicates to perform FEC bypass, the first device processes the first data in a manner of performing FEC bypass corresponding to the current operation mode, to obtain the second data. The manner of performing FEC bypass is determined based on an FEC code type. Because the manner of performing FEC bypass is determined based on the FEC code type, and the FEC code type may affect a latency and the like in the data transmission process, processing the first data in the manner of performing FEC bypass to obtain the second data helps meet a latency requirement and the like in a transmission process of the second data.

In a possible implementation, performing FEC bypass includes at least one of the following: The first device does not perform an FEC encoding operation; and the second device does not perform an FEC decoding operation. For example, the first device may perform the FEC encoding operation, and the second device may not perform the FEC decoding operation. For another example, the first device may not perform the FEC encoding operation, and the second device may not perform the FEC decoding operation.

In a possible implementation, the current operation mode indicates to perform FEC bypass if the capabilities of the first device and the second device meet the following cases: Both the first device and the second device support an 802.3 standard; both the first device and the second device support an FEC bypass ability; and at least one of the first device and the second device requests FEC bypass. When all the three cases are met, it indicates that the first device and the second device may normally perform FEC bypass, so that the current operation mode can indicate to perform FEC bypass. Therefore, it can be ensured that the indication of the current operation mode can be supported by the capabilities of the first device and the second device.

In a possible implementation, the current operation mode indicates not to perform FEC bypass if the capabilities of the first device and the second device meet at least one of the following cases: At least one of the first device and the second device does not support an 802.3 standard; at least one of the first device and the second device does not support an FEC bypass ability; and neither the first device nor the second device request FEC bypass. In other words, if one, two, or three of the three cases are not met, neither the first device nor the second device can perform FEC bypass, so that the current operation mode can indicate not to perform FEC bypass. Therefore, it can also be ensured that the indication of the current operation mode can be supported by the capabilities of the first device and the second device.

In a possible implementation, before the first device processes the first data based on the current operation mode, to obtain the second data, the method further includes: The first device exchanges auto-negotiation pages with the second device, and determines the current operation mode based on technology ability fields in base pages carried in the auto-negotiation pages. In this implementation, the first device negotiates with the second device to obtain the current operation mode by exchanging the auto-negotiation pages. This manner is simple and easy to implement, and has strong applicability.

In a possible implementation, that the first device exchanges the auto-negotiation pages with the second device, and determines the current operation mode based on the technology ability fields in the base pages carried in the auto-negotiation pages includes: The first device generates a first auto-negotiation page, and sends the first auto-negotiation page to the second device. The first device receives a second auto-negotiation page sent by the second device, and determines the current operation mode based on a first identifier, a second identifier, a third identifier, a fourth identifier, a fifth identifier, and a sixth identifier. The first auto-negotiation page carries the base page, and the technology ability field in the base page includes the first identifier, the second identifier, and the third identifier. The first identifier indicates whether the first device supports the 802.3 standard, the second identifier indicates whether the first device requests FEC bypass, and the third identifier indicates whether the first device supports the FEC bypass ability. The second auto-negotiation page carries the base page, the technology ability field in the base page includes the fourth identifier, the fifth identifier, and the sixth identifier, the fourth identifier indicates whether the second device supports the 802.3 standard, the fifth identifier indicates whether the second device requests FEC bypass, and the sixth identifier indicates whether the second device supports the FEC bypass ability. In this implementation, different capabilities of the first device and the second device are carried in different identifiers. This has high feasibility and is easy to implement.

In a possible implementation, that the first device processes the first data based on the current operation mode, to obtain the second data includes: When the current operation mode indicates not to perform FEC bypass, the first device performs codeword conversion, aggregation, FEC encoding, scrambling, and symbol mapping on the first data, to obtain the second data. In addition to FEC encoding, the first device further performs a plurality of other types of processing, to further improve the reliability of data transmission.

According to a second aspect, a physical layer data transmission method is provided. The method includes: After receiving second data sent by a first device, a second device processes the second data based on a current operation mode, to obtain first data. The current operation mode indicates whether to perform FEC bypass, and the current operation mode is determined based on capabilities of the first device and a second device.

In a possible implementation, that the second device receives the second data sent by the first device includes: The second device receives, via an SPE, the second data sent by the first device.

In a possible implementation, that the second device processes the second data based on the current operation mode, to obtain the first data includes: When the current operation mode indicates to perform FEC bypass, the second device processes the second data in a manner of performing FEC bypass corresponding to the current operation mode, to obtain the first data. The manner of performing FEC bypass is determined based on an FEC code type.

In a possible implementation, performing FEC bypass includes at least one of the following: The first device does not perform an FEC encoding operation; and the second device does not perform an FEC decoding operation.

In a possible implementation, the current operation mode indicates to perform FEC bypass if the capabilities of the first device and the second device meet the following cases: Both the first device and the second device support an 802.3 standard; both the first device and the second device support an FEC bypass ability; and at least one of the first device and the second device requests FEC bypass.

In a possible implementation, the current operation mode indicates not to perform FEC bypass if the capabilities of the first device and the second device meet at least one of the following cases: At least one of the first device and the second device does not support an 802.3 standard; at least one of the first device and the second device does not support an FEC bypass ability; and neither the first device nor the second device request FEC bypass.

In a possible implementation, before the second device processes the second data based on the current operation mode, to obtain the first data, the method further includes: The second device exchanges auto-negotiation pages with the first device, and determines the current operation mode based on technology ability fields in base pages carried in the auto-negotiation pages.

In a possible implementation, that the second device exchanges the auto-negotiation pages with the first device, and determines the current operation mode based on the technology ability fields in the base pages carried in the auto-negotiation pages includes: The second device receives a first auto-negotiation page sent by the first device. The second device generates a second auto-negotiation page, and sends the second auto-negotiation page to the first device. The second device determines the current operation mode based on a first identifier, a second identifier, a third identifier, a fourth identifier, a fifth identifier, and a sixth identifier.

The first auto-negotiation page carries the base page, and the technology ability field in the base page includes the first identifier, the second identifier, and the third identifier. The first identifier indicates whether the first device supports the 802.3 standard, the second identifier indicates whether the first device requests FEC bypass, and the third identifier indicates whether the first device supports the FEC bypass ability. The second auto-negotiation page carries the base page, the technology ability field in the base page includes the fourth identifier, the fifth identifier, and the sixth identifier, the fourth identifier indicates whether the second device supports the 802.3 standard, the fifth identifier indicates whether the second device requests FEC bypass, and the sixth identifier indicates whether the second device supports the FEC bypass ability.

In a possible implementation, that the second device processes the second data based on the current operation mode, to obtain the first data includes: When the current operation mode indicates not to perform FEC bypass, the second device performs symbol demapping, descrambling, FEC decoding, separation, and codeword conversion on the second data, to obtain the first data.

According to a third aspect, a physical layer data transmission apparatus is provided. The apparatus is used in a first device, and the apparatus includes:
an obtaining module, configured to obtain first data;
a processing module, configured to process the first data based on a current operation mode, to obtain second data, where the current operation mode indicates whether to perform FEC bypass, and the current operation mode is determined based on capabilities of the first device and a second device; and
a sending module, configured to send the second data to the second device.

In a possible implementation, the sending module is configured to send the second data to the second device via an SPE.

In a possible implementation, the processing module is configured to: when the current operation mode indicates to perform FEC bypass, process the first data in a manner of performing FEC bypass corresponding to the current operation mode, to obtain the second data. The manner of performing FEC bypass is determined based on an FEC code type.

In a possible implementation, performing FEC bypass includes at least one of the following: The first device does not perform an FEC encoding operation; and the second device does not perform an FEC decoding operation.

In a possible implementation, the current operation mode indicates to perform FEC bypass if the capabilities of the first device and the second device meet the following cases: Both the first device and the second device support an 802.3 standard; both the first device and the second device support an FEC bypass ability; and at least one of the first device and the second device requests FEC bypass.

In a possible implementation, the current operation mode indicates not to perform FEC bypass if the capabilities of the first device and the second device meet at least one of the following cases: At least one of the first device and the second device does not support an 802.3 standard; at least one of the first device and the second device does not support an FEC bypass ability; and neither the first device nor the second device request FEC bypass.

In a possible implementation, the apparatus further includes: a negotiation module, configured to: exchange auto-negotiation pages with the second device, and determine the current operation mode based on technology ability fields in base pages carried in the auto-negotiation pages.

In a possible implementation, the negotiation module is configured to: generate a first auto-negotiation page, and send the first auto-negotiation page to the second device, where the first auto-negotiation page carries the base page, the technology ability field in the base page includes a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability; receive a second auto-negotiation page sent by the second device, where the second auto-negotiation page carries the base page, the technology ability field in the base page includes a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and determine the current operation mode based on the first identifier, the second identifier, the third identifier, the fourth identifier, the fifth identifier, and the sixth identifier.

In a possible implementation, the processing module is configured to: when the current operation mode indicates not to perform FEC bypass, perform codeword conversion, aggregation, FEC encoding, scrambling, and symbol mapping on the first data, to obtain the second data.

According to a fourth aspect, a physical layer data transmission apparatus is provided. The apparatus is used in a second device, and the apparatus includes:
a receiving module, configured to receive second data sent by a first device; and
a processing module, configured to process the second data based on a current operation mode, to obtain first data, where the current operation mode indicates whether to perform FEC bypass, and the current operation mode is determined based on capabilities of the first device and the second device.

In a possible implementation, the receiving module is configured to receive, via an SPE, the second data sent by the first device.

In a possible implementation, the processing module is configured to: when the current operation mode indicates to perform FEC bypass, process the second data in a manner of performing FEC bypass corresponding to the current operation mode, to obtain the first data. The manner of performing FEC bypass is determined based on an FEC code type.

In a possible implementation, performing FEC bypass includes at least one of the following: The first device does not perform an FEC encoding operation; and the second device does not perform an FEC decoding operation.

In a possible implementation, the current operation mode indicates to perform FEC bypass if the capabilities of the first device and the second device meet the following cases: Both the first device and the second device support an 802.3 standard; both the first device and the second device support an FEC bypass ability; and at least one of the first device and the second device requests FEC bypass.

In a possible implementation, the current operation mode indicates not to perform FEC bypass if the capabilities of the first device and the second device meet at least one of the following cases: At least one of the first device and the second device does not support an 802.3 standard; at least one of the first device and the second device does not support an FEC bypass ability; and neither the first device nor the second device request FEC bypass.

In a possible implementation, the apparatus further includes: a negotiation module, configured to: exchange auto-negotiation pages with the first device, and determine the current operation mode based on technology ability fields in base pages carried in the auto-negotiation pages.

In a possible implementation, the negotiation module is configured to: receive a first auto-negotiation page sent by the first device, where the first auto-negotiation page carries the base page, the technology ability field in the base page includes a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability; generate a second auto-negotiation page, and send the second auto-negotiation page to the first device, where the second auto-negotiation page carries the base page, the technology ability field in the base page includes a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and determine the current operation mode based on the first identifier, the second identifier, the third identifier, the fourth identifier, the fifth identifier, and the sixth identifier.

In a possible implementation, the processing module is configured to: when the current operation mode indicates not to perform FEC bypass, perform symbol demapping, descrambling, FEC decoding, separation, and codeword conversion on the second data, to obtain the first data.

According to a fifth aspect, a physical layer data transmission system is provided. The system includes a first device and a second device. The first device is configured to perform the physical layer data transmission method provided in any one of the first aspect or the possible implementations of the first aspect. The second device is configured to perform the physical layer data transmission method provided in any one of the second aspect or the possible implementations of the second aspect.

According to a sixth aspect, a physical layer data transmission device is provided. The device includes a memory and a processor. The memory stores at least one instruction, and the at least one instruction is loaded and executed by the processor, to cause the device to perform the physical layer data transmission method in the foregoing aspects.

Optionally, there are one or more processors, and there are one or more memories.

Optionally, the memory may be integrated with the processor, or the memory and the processor are disposed separately.

According to a seventh aspect, a chip is provided. The chip includes a processor, and the processor is configured to: invoke instructions stored in a memory, and run the instructions, to cause a computer in which the chip is installed to perform the physical layer data transmission method in the foregoing aspects.

According to an eighth aspect, another chip is provided, including an input interface, an output interface, a processor, and a memory. The input interface, the output interface, the processor, and the memory are connected through an internal connection path. The processor is configured to execute code in the memory, and when the code is executed, a computer in which the chip is installed performs the physical layer data transmission method in the foregoing aspects.

According to a ninth aspect, a computer program (product) is provided. The computer program (product) includes computer program code, and when the computer program code is run by a computer, the computer is caused to perform the physical layer data transmission method in the foregoing aspects.

According to a tenth aspect, a computer-readable storage medium is provided. The computer-readable storage medium stores a program or instructions, and when the program or the instructions are run on a computer, the physical layer data transmission method in the foregoing aspects is performed.

It should be understood that, for beneficial effects achieved by the technical solutions of the second aspect to the tenth aspect of this application and the corresponding possible implementations, refer to the technical effects of the first aspect and the corresponding possible implementations. Details are not described herein again.

### BRIEF DESCRIPTION OF DRAWINGS

FIG. 1 is a diagram of an implementation environment according to an embodiment of this application;
FIG. 2 is a flowchart of a physical layer data transmission method according to an embodiment of this application;
FIG. 3 is a diagram of a transition position according to an embodiment of this application;
FIG. 4 is a diagram of a structure of an auto-negotiation page according to an embodiment of this application;
FIG. 5 is a diagram of Manner 1 of performing FEC bypass according to an embodiment of this application;
FIG. 6 is a diagram of Manner 2 of performing FEC bypass according to an embodiment of this application;
FIG. 7 is a diagram of Manner 3 of performing FEC bypass according to an embodiment of this application;
FIG. 8 is a flowchart of data transmission according to an embodiment of this application;
FIG. 9 is another flowchart of data transmission according to an embodiment of this application;
FIG. 10 is a diagram of a structure of a physical layer data transmission apparatus according to an embodiment of this application;
FIG. 11 is a diagram of a structure of another physical layer data transmission apparatus according to an embodiment of this application; and
FIG. 12 is a diagram of a structure of a physical layer data transmission device according to an embodiment of this application.

### DESCRIPTION OF EMBODIMENTS

Terms used in implementations of this application are merely used to explain embodiments of this application, but are not intended to limit this application.

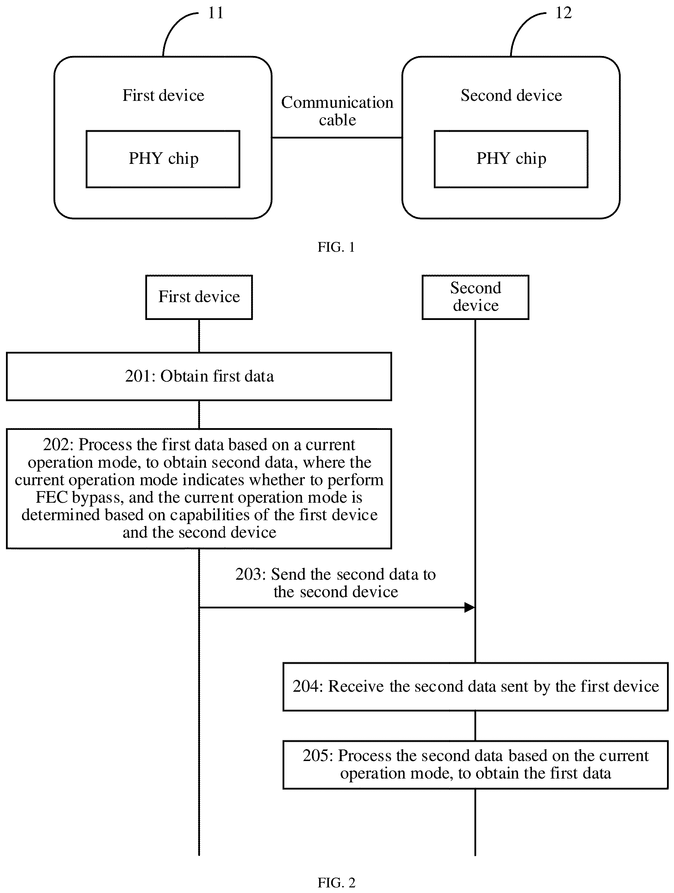

An embodiment of this application provides an implementation environment in which a physical layer data transmission method provided in embodiments of this application is implemented. As shown in FIG. 1, the implementation environment includes a first device 11 and a second device 12. The first device 11 is communicatively connected to the second device 12, to perform data transmission at a physical layer over the communication connection.

For example, still refer to FIG. 1. The first device 11 and the second device 12 each include a physical layer (physical layer, PHY) chip, and the PHY chip included in the first device 11 and the PHY chip included in the second device 12 are separately connected to a communication cable, to implement the communication connection between the first device 11 and the second device 12. Optionally, any PHY chip is connected to the communication cable through a medium dependent interface (medium dependent interface, MDI).

The communication cable is not limited in embodiments of this application. The communication cable is, for example, a single twisted pair (single twisted pair 1, STP), which is briefly referred to as a single pair. The single twisted pair is a cable formed by twisting a pair of conducting wires with an insulation protection layer. In comparison with a conventional four-twisted pair, the single twisted pair has advantages including simple deployment, low costs, light weight, small interface, and strong adaptability, and has a good application prospect.

The implementation environment shown in FIG. 1 may correspond to a plurality of scenarios, for example, a long-distance scenario and a low-latency scenario. The long-distance scenario means that the first device and the second device far from each other need to perform long-distance data transmission, where the long distance is, for example, greater than 100 meters or may as long as 500 meters. The low-latency scenario means that the first device and the second device need to perform data transmission with a low latency, where the latency for transmission from the first device to the second device (or transmission from the second device to the first device) is less than a specific time threshold, for example, 1.5 microseconds. For example, the latency is a physical layer latency, which is time consumed for data transmission at a physical layer.

In some implementations, the long-distance scenario includes a process industrial scenario. In the process industrial scenario, there is a long distance of 500 meters between the first device and the second device, and a bandwidth between the first device and the second device is 100 megabits per second (megabits per second, Mbps).

In some other implementations, the low-latency scenario includes an automatic control scenario, and the automatic control scenario may be used to automatically control an instrument like a servo motor. In the automatic control scenario, there is a short distance of 100 meters between the first device and the second device, a bandwidth between the first device and the second device is 100 Mbps, and a low latency is needed for data transmission between the first device and the second device.

Both the foregoing process industrial scenario and automatic control scenario belong to industrial internet of things scenarios. In addition, an office internet of things scenario used to implement building automation may belong to a long-distance scenario or a low-latency scenario. In the office internet of things scenario, the first device and the second device may be located in a same building, or may be located in different buildings. It is clear that, in addition to the industrial internet of things scenario and the office internet of things scenario, another existing internet of things scenario or an internet of things scenario that may appear in the future may also belong to at least one of a long-distance scenario and a low-latency scenario. This is not limited herein.

In the long-distance scenario, although the latency requirement is not high, signal attenuation increases due to the long distance, there is large crosstalk between different communication cables and strong external common-mode noise resulting from the plurality of communication cables which may need to be bundled and routed. Consequently, in the long-distance scenario, an SNR is low and immunity deteriorates. Therefore, there is a need to perform FEC to improve an SNR margin.

However, in the low-latency scenario, there is small signal attenuation and almost no crosstalk between different communication cables due to a short distance, and external common-mode noise can be effectively suppressed since there is usually sufficient shielding protection. Therefore, immunity is strong, and a signal-to-noise ratio is high. However, because the latency requirement is high, and performing FEC increases a latency in a data transmission process, FEC bypass needs to be performed, in other words, there is no need to perform FEC.

It can be learned that FEC needs to be performed in the long-distance scenario whereas FEC bypass needs to be performed in the low-latency scenario. Requirements for FEC in the two scenarios are opposite. Therefore, in a physical layer data transmission process, whether to use FEC needs to be properly determined. In other words, whether to perform FEC bypass needs to be properly determined, to ensure that both the long-distance scenario and the low-latency scenario can be supported.

Embodiments of this application provide a physical layer data transmission method. The method may be implemented through interaction between the first device and the second device that are included in the implementation environment shown in FIG. 1. For example, when steps in the method are performed by the first device, the PHY chip included in the first device is configured to perform the steps. When steps in the method are performed by the second device, the PHY chip included in the second device is configured to perform the steps. As shown in FIG. 2, the method includes the following steps 201 to 205.

Step 201: The first device obtains first data.

The first data is, for example, a bit (bit) stream, and is also referred to as a bit sequence. A manner of obtaining the first data is not limited in this embodiment of this application. For example, when the PHY chip included in the first device obtains the first data, the PHY chip may receive, through a reference interface, the first data sent by a media access control (media access control, MAC) layer. The reference interface includes but is not limited to a media independent interface (media independent interface, MII), a gigabit MII (gigabit MII, GMII), a reduced GMII (reduced GMII, RGMII), and the like. This is not limited herein.

Step 202: The first device processes the first data based on a current operation mode, to obtain second data, where the current operation mode indicates whether to perform FEC bypass, and the current operation mode is determined based on capabilities of the first device and the second device.

The first device needs to process the first data based on the current operation mode, to obtain the second data, so that the second data is subsequently sent to the second device through a physical layer. In this case, the second device may correspondingly process the second data based on the current operation mode, to obtain the first data. The second data is, for example, a symbol (symbol) stream, and is also referred to as a symbol sequence. The current operation mode indicates whether to perform FEC bypass (bypass). In embodiments of this application, bypassing a process means not to perform the process. Therefore, whether to perform FEC bypass means whether FEC is not performed. For example, it is considered that FEC includes an FEC encoding operation and an FEC decoding operation, the FEC encoding operation is performed by a data transmitting end (namely, the first device configured to send the second data), and the FEC decoding operation is performed by a data receiving end (namely, the second device configured to receive the second data). Therefore, performing FEC bypass may include at least one of the following: The first device does not perform the FEC encoding operation, and the second device does not perform the FEC decoding operation. That the first device does not perform the FEC encoding operation means that the first device does not perform the FEC encoding operation in a process in which the first device processes the first data to obtain the second data. That the second device does not perform the FEC decoding operation means that the second device does not perform the FEC decoding operation in a process in which the second device processes the second data to obtain the first data. Correspondingly, not performing FEC bypass may include: The first device performs the FEC encoding operation and the second device performs the FEC decoding operation.

Optionally, the FEC encoding operation corresponds to the FEC decoding operation. In other words, the FEC encoding operation and the FEC decoding operation are inverse processes to each other. Therefore, the FEC encoding operation and the FEC decoding operation have a same FEC code type. The FEC code type includes but is not limited to at least one of the following: a Reed-Solomon (Reed-Solomon, RS) code, a trellis coded modulation (trellis coded modulation, TCM) code, a low-density parity-check (low-density parity-check, LDPC) code, a Bose-Chaudhuri-Hocquenghem (Bose-Chaudhuri-Hocquenghem, BCH) code, an extended BCH code, a Hamming code, an extended Hamming code, a fire (fire) code, a turbo (turbo) code, a turbo product code (turbo product code, TPC), a staircase (staircase) code, and the like. This is not limited herein.

For example, it is considered that there is usually another executable process in addition to FEC. In this case, performing FEC bypass may further include: The first device does not perform at least one executable process corresponding to the first device, and the second device does not perform at least one executable process corresponding to the second device. Correspondingly, not performing FEC bypass may further include: The first device performs each executable process corresponding to the first device, and the second device performs each executable process corresponding to the second device.

For example, executable processes corresponding to the first device include but are not limited to codeword conversion, aggregation, scrambling, and symbol mapping. The codeword conversion is used to convert individual bits in a bit stream into blocks (blocks), where each block may include a plurality of bits. A codeword conversion manner includes but is not limited to 64B/65B, 80B/81B, and the like. This is not limited herein. For example, 64B/65B means that 64 individual bits in a bitstream are converted into a block including 65 bits, and 80B/81B means that 80 individual bits in a bitstream are converted into a block including 81 bits. The aggregation is used to combine an integer quantity of blocks, and padding may be performed with an additional bit, for example, a meaningless bit or an operations, administration, and maintenance (operations, administration, and maintenance, OAM) field, based on an actual requirement, to obtain an aggregation result. The scrambling is used to perform regular randomization processing on a bit, to obtain a scrambling result. The symbol mapping is used to modulate a bit into a symbol having a specific order. Modulation schemes include but are not limited to not return to zero (not return to zero, NRZ) modulation, 3-level pulse amplitude modulation (3-level pulse amplitude modulation, PAM3), 4-level pulse amplitude modulation (4-level pulse amplitude modulation, PAM4), 5-level pulse amplitude modulation (5-level pulse amplitude modulation, PAM5), and the like.

For another example, for the second device, other executable processes include but are not limited to codeword conversion, separation, descrambling, and symbol demapping. The codeword conversion performed by the second device is an inverse process of the codeword conversion performed by the first device, and the codeword conversion performed by the second device is used to convert a block into individual bits. The separation is an inverse process of the aggregation. The separation is used to remove the additional bit for padding during the aggregation, and separate the aggregation result into an integer quantity of blocks. The descrambling is an inverse process of the scrambling, and the descrambling is used to restore the scrambling result to an unscrambled bit. The symbol demapping is an inverse process of the symbol mapping, and the symbol demapping is used to demodulate the symbol having a specific order into a bit.

The foregoing describes a definition of performing FEC bypass or not performing FEC bypass. Whether to perform FEC bypass is indicated by the current operation mode, and the current operation mode is determined based on the capabilities of the first device and the second device. Therefore, when the capabilities of the first device and the second device meet different cases, current operation modes are also correspondingly different. For example, cases met by the capability of the first device and the capability of the second device may include the following two implementations.

Implementation 1: The current operation mode indicates to perform FEC bypass if the capabilities of the first device and the second device meet the following cases: Both the first device and the second device support an 802.3 standard; both the first device and the second device support an FEC bypass ability; and at least one of the first device and the second device requests FEC bypass.

In other words, if both the first device and the second device can support the 802.3 standard and can perform FEC bypass, and at least one of the first device and the second device can request to perform FEC bypass, the first device and the second device may normally perform FEC bypass. In this case, the current operation mode indicates to perform FEC bypass.

For example, the 802.3 standard is a standard proposed by the institute of electrical and electronics engineers (institute of electrical and electronics engineers, IEEE). That both the first device and the second device can support the 802.3 standard may mean that the first device and the second device can perform physical layer data transmission by using a technology defined in the 802.3 standard. For example, the 802.3 standard includes an 802.3dg standard, and the technology defined in the 802.3dg standard is 100BASE-T1L. 100BASE-T1L belongs to a point to point (point to point, P2P) advanced physical layer (advanced physical layer, APL) phase II (phase II) technology. 100 represents that a bandwidth is 100 Mbps, BASE represents a baseband (baseband), T1 represents a single twisted pair, and L represents a long distance (long). The long distance may be greater than 100 meters, for example, 500 meters. It should be understood that the technology defined in the 802.3 standard may not only include 100BASE-T1L, but also include other conventional technologies or future technologies. This is not limited herein.

In comparison with a 10BASE-T1S technology in an 802.3cg standard (where 10 represents that a bandwidth is 10 Mbps, and S represents a short distance (short), for example, 15 meters), 100BASE-T1L has a higher bandwidth, can support a higher data transmission rate, and can support a long-distance data transmission scenario. In comparison with a 10BASE-T1L technology in the 802.3cg standard, 100BASE-T1L has a higher bandwidth and can support a higher data transmission rate. In addition, in comparison with a 100BASE-T1 technology in an 802.3bw standard, 100BASE-T1L can support a long-distance data transmission scenario.

Implementation 2: The current operation mode indicates not to perform FEC bypass if the capabilities of the first device and the second device meet at least one of the following cases: At least one of the first device and the second device does not support an 802.3 standard; at least one of the first device and the second device does not support an FEC bypass ability; and neither the first device nor the second device request FEC bypass.

In other words, if at least one of the first device and the second device cannot support the 802.3 standard, or cannot perform FEC bypass, or cannot support the 802.3 standard and cannot perform FEC bypass, neither the first device nor the second device can normally perform FEC bypass, regardless of whether at least one device can request to perform FEC bypass. In this case, the current operation mode indicates not to perform FEC bypass. Even if both the first device and the second device can support the 802.3 standard and can perform FEC bypass, but no device can request to perform FEC bypass, the first device and the second device also cannot normally perform FEC bypass. In this case, the current operation mode also indicates not to perform FEC bypass.

It is clear that, regardless of whether the current operation mode indicates to perform FEC bypass or indicates not to perform FEC bypass, the current operation mode needs to be determined before step 202 is performed. For example, the capabilities of the first device and the second device may be determined manually or by a third device, the current operation mode is correspondingly determined, and then the current operation mode is configured for the first device and the second device. The third device is, for example, a device other than the first device and the second device. Alternatively, the current operation mode may be obtained through negotiation between the first device and the second device. Because the first device can determine the capability of the local end, and the second device can also determine the capability of the local end, the negotiation process is to cause the first device to determine the capability of the second device, and cause the second device to determine the capability of the first device. In this way, the first device and the second device can separately determine the current operation mode based on the capabilities of the first device and the second device.

Therefore, in an example embodiment, before the first device processes the first data based on the current operation mode, to obtain the second data, the method further includes: The first device exchanges auto-negotiation pages with the second device, and determines the current operation mode based on technology ability fields in base pages (base pages) carried in the auto-negotiation pages. Correspondingly, the second device also exchanges the auto-negotiation pages with the first device, and determines the current operation mode based on the technology ability fields in the base pages carried in the auto-negotiation pages. The technology ability fields in the base pages may be used to carry the capability of the first device, so that the second device can determine the capability of the first device, and may be further used to carry the capability of the second device, so that the first device can determine the capability of the second device, to implement the foregoing negotiation process. It should be understood that both the base page and the technology ability field are examples, and are not used to limit this embodiment of this application. The first device and the second device may alternatively obtain the current operation mode through negotiation based on an actual requirement by using another field.

For example, that the first device and the second device determine the current operation mode based on the technology ability fields in the base pages carried in the auto-negotiation pages includes the following step 2021 to step 2026.

Step 2021: The first device generates a first auto-negotiation page, and sends the first auto-negotiation page to the second device.

Because both the first device and the second device support the 802.3 standard, the first device and the second device may perform negotiation based on a mechanism defined in the 802.3 standard. For example, an SPE auto negotiation mechanism is defined in the 802.3 standard. In this mechanism, different devices perform negotiation in a half-duplex manner, and differential Manchester encoding (DME) is used for an auto-negotiation page used for negotiation. In this case, the auto-negotiation page is also referred to as a DME page (DME page). Therefore, the first auto-negotiation page generated by the first device may be the DME page. The following describes a page structure of the DME page.

The DME page includes a plurality of transition positions, there is a transition position spacing between every two transition positions, and a page length of the DME page is a sum of lengths of all transition position spacings. An odd-numbered transition position represents a clock, and an even-numbered transition position represents data. That is, the clock and the data appear alternately. A transition is present in the odd-numbered transition position by default, and that a transition is present means a transition to a low level or a transition to a high level. A transition may be present in or absent from the even-numbered transition position, and that a transition is absent means remaining at the high level or remaining at the low level. If a transition is present in the even-numbered transition position, the even-numbered transition position represents 1. If a transition is absent from the even-numbered transition position, the even-numbered transition position represents 0.

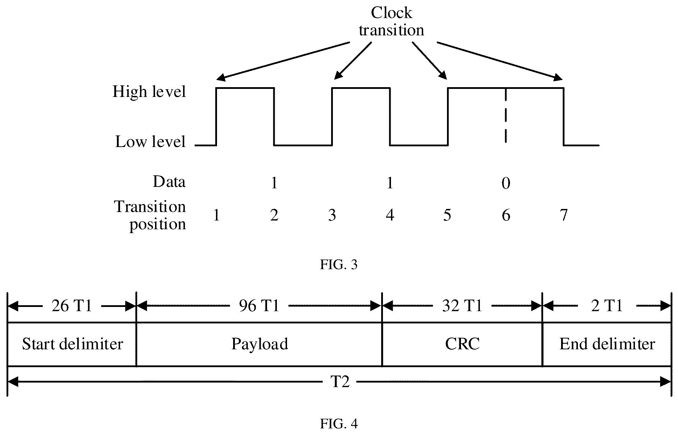

For example, refer to FIG. 3. A transition position 1 represents a clock, and the clock jumps from a low level to a high level. A transition position 2 represents data. Because the data jumps from the high level to the low level and the transition is present, the data represents 1. A transition position 3 represents the clock, and the clock jumps from the low level to the high level. A transition position 4 represents the data. Because the data jumps from the high level to the low level, and the transition is present, the data represents 1. A transition position 5 represents the clock, and the clock jumps from the low level to the high level. A transition position 6 represents the data. Because the high level remains and a transition is absent, the data represents 0. A transition position 7 represents the clock, and the clock jumps from the high level to the low level. Therefore, based on the seven transition positions shown in FIG. 3, it can be obtained that the data is 110.

As shown in FIG. 4, the DME page includes a start delimiter, a payload, a cyclic redundancy check (cyclic redundancy check, CRC), and an end delimiter. For example, if the DME page includes 157 transition positions (79 clocks and 78 bits of data), and corresponds to 156 transition position spacings T1, a page length T2 of the DME page is a sum of lengths of the 156 transition position spacings T1.

For example, the start delimiter may include 26 transition position spacings T1, and the start delimiter may randomly jump from a zero level to a high level, or may randomly jump from a zero level to a low level at a 1^{st} transition position. When the start delimiter jumps from the zero level to the high level, the start delimiter carries a first fixed sequence, or when the start delimiter jumps from the zero level to the low level, the start delimiter carries a second fixed sequence. Because the start delimiter randomly jumps at the 1^{st} transition position, the start delimiter randomly carries the first fixed sequence or the second fixed sequence, and does not always carry the first fixed sequence or always carry the second fixed sequence, so that a periodic spectrum peak is not generated. The CRC may include 32 transition position spacings T1, and carry a 16-bit CRC check codeword. A polynomial used in a process of generating the CRC check codeword may be x¹⁶+x¹⁵+x²+1, or the like. This is not limited herein. The end delimiter may include two transition position spacings T1.

The payload includes 96 transition position spacings T1, and carries 48 bits of data. The 48 bits of data are the base page. The 48 bits of data included in the base page may be divided into a plurality of bits or fields, and different bits or fields are used to implement different functions. For example, refer to Table 1. The 48 bits of data included in the base page are represented as D0 to D47, D0 to D4 belong to a selector field (selector field) S[4:0], D5 to D9 belong to an echoed nonce field (echoed nonce field) E[4:0], D10 and D11 belong to C[1:0], where C[1:0] is used to advertise a pause ability (pause ability). D12 is a force master/slave (force master/slave, M/S) bit, D13 is a remote fault (remote fault, RF) bit, D14 is an acknowledgment (acknowledgement, ACK) bit, and D15 is a next page (next page, NP) bit. D16 to D20 belong to a transmitted nonce field (transmitted nonce field) T[4:0], D21 to D47 belong to a technology ability field (technology ability field) A[26:0], and the like.

**Table 1**

| D0 | D1 | D2 | D3 | D4 | D5 | D6 | D7 | D8 | D9 | D10 | D11 |
|---|---|---|---|---|---|---|---|---|---|---|---|
| S0 | S1 | S2 | S3 | S4 | E0 | E1 | E2 | E3 | E4 | C0 | C1 |
| D12 | D13 | D14 | D15 | D16 | D17 | D18 | D19 | D20 | D21 | D22 | D23 |
| M/S | RF | ACK | NP | T0 | T1 | T2 | T3 | T4 | A0 | A1 | A2 |
| D24 | D25 | D26 | D27 | D28 | D29 | D30 | D31 | D32 | D33 | D34 | D35 |
| A3 | A4 | A5 | A6 | A7 | A8 | A9 | A10 | A11 | A12 | A13 | A14 |
| D36 | D37 | D38 | D39 | D40 | D41 | D42 | D43 | D44 | D45 | D46 | D47 |
| A15 | A16 | A17 | A18 | A19 | A20 | A21 | A22 | A23 | A24 | A25 | A26 |

Because the first auto-negotiation page may be the DME page, the first auto-negotiation page carries the base page. It is considered that the technology ability field in the base page may be used to implement capability exchange between different devices. Therefore, in this embodiment of this application, the first auto-negotiation page carries the capability of the first device in the technology ability field, so that after the first device sends the first auto-negotiation page to the second device, the second device can determine the capability of the first device. Therefore, the technology ability field in the base page includes a first identifier, a second identifier, and a third identifier. The first identifier indicates whether the first device supports the 802.3 standard, the second identifier indicates whether the first device requests FEC bypass, and the third identifier indicates whether the first device supports the FEC bypass ability.

Because the technology ability field is A[26:0], the technology ability field includes 27 bits in total from A0 to A26. For capabilities, in other words, selector descriptions (selector descriptions) corresponding to the 27 bits, refer to the following Table 2.

**Table 2**

| Bit | Capability |
|---|---|
| A0 | 100BASE-T1 capability |
| A1 | 10BASE-T1S full duplex (full duplex) capability |
| A2 | 1000BASE-T1 capability, where 1000 represents 1000 Mbps |
| A3 | 2.5GBASE-T1 capability, where 2.5G represents 2.5 gigabits per second (gigabits per second, Gbps) |
| A4 | SGBASE-T1 capability, where 5G represents 5 Gbps |
| A5 | 10GBASE-T1 capability, where 10G represents 10 Gbps |
| A6 | 25GBASE-T1 capability, where 25G represents 25 Gbps |
| A7 and A8 | Reserved (reserved) |
| A9 | 10BASE-T1L capability, where 10 represents 10 Mbps |
| A10 to A21 | Reserved |
| A22 | 10BASE-T1S half duplex (half duplex) |
| A23 | 10BASE-T1L increased transmit level request (increased transmit level request) |
| A24 | 10BASE-T1L increased transmit/receive level (increased transmit/receive level) capability |
| A25 | 10BASE-T1L energy efficient Ethernet (energy efficient Ethernet, EEE) capability |
| A26 | Reserved |

For example, based on Table 2, in this embodiment of this application, the first identifier, the second identifier, and the third identifier may be carried in reserved bits (for example, A7, A8, A10 to A21, and A26) in the technology ability field. In addition, bits that are in the plurality of reserved bits and that are used to carry the first identifier, the second identifier, and the third identifier are not limited. For example, the first identifier may be carried in A8, the second identifier may be carried in A20, and the third identifier may be carried in A21. For example, supporting the 802.3 standard means that 100BASE-T1L can be used to perform physical layer data transmission. In this case, capabilities of the three bits A8, A20, and A21 may be updated from reserved in Table 2 to capabilities in the following Table 3.

**Table 3**

| Bit | Capability |
|---|---|
| A8 | 100BASE-T1L capability |
| A20 | 100BASE-T1L FEC bypass request |
| A21 | 100BASE-T1L FEC bypass ability |

Optionally, when a reserved bit carries the first identifier, if a value of the first identifier is a first value, it indicates that the 802.3 standard is supported; or if a value of the first identifier is a second value, it indicates that the 802.3 standard is not supported. When a reserved bit carries the second identifier, if a value of the second identifier is a third value, it indicates that FEC bypass is requested; or if a value of the second identifier is a fourth value, it indicates that FEC bypass is not requested. When a reserved bit carries the third identifier, if a value of the third identifier is a fifth value, it indicates that the FEC bypass ability is supported; or if a value of the third identifier is a sixth value, it indicates that the FEC bypass ability is not supported. For example, when the value of the first identifier indicates that the 802.3 standard is not supported, it may be considered that the values of the second identifier and the third identifier are invalid. In addition, the foregoing values are not limited in this embodiment of this application, and different values may be the same or may be different. The first value, the third value, and the fifth value may be, for example, 1, and the second value, the fourth value, and the sixth value may be, for example, 0.

When the first device needs to generate the first auto-negotiation page, the first device may read a register (register) to separately obtain the value of the first identifier, the value of the second identifier, and the value of the third identifier. Then, the first auto-negotiation page is generated based on the read values of the identifiers, so that, in the technology ability field included in the base page carried in the first auto-negotiation page, a bit carrying the first identifier has the value of the first identifier, a bit carrying the second identifier has the value of the second identifier, and a bit carrying the third identifier has the value of the third identifier. After generating the first auto-negotiation page, the first device may send the first auto-negotiation page to the second device.

For example, the first device may send the first auto-negotiation page to the second device via an SPE. In comparison with single pair technologies with a low bandwidth, for example, RS485 and a controller area network (controller area network, CAN), the SPE can support a bandwidth higher than 10 Mbps and can support a long transmission distance.

Step 2022: The second device receives the first auto-negotiation page sent by the first device.

Because the first device has sent the first auto-negotiation page to the second device, the second device correspondingly receives the first auto-negotiation page sent by the first device. For example, when the first device sends the first auto-negotiation page to the second device via the SPE, the second device also correspondingly receives the first auto-negotiation page via the SPE.

Step 2023: The second device generates a second auto-negotiation page, and sends the second auto-negotiation page to the first device.

The second auto-negotiation page carries the base page, the technology ability field in the base page includes a fourth identifier, a fifth identifier, and a sixth identifier, the fourth identifier indicates whether the second device supports the 802.3 standard, the fifth identifier indicates whether the second device requests FEC bypass, and the fifth identifier indicates whether the second device supports the FEC bypass ability. For example, in this embodiment of this application, the fourth identifier, the fifth identifier, and the sixth identifier may be carried in the reserved fields shown in Table 2 in the technology ability field. For example, the fourth identifier is carried in A8, the fifth identifier is carried in A20, and the sixth identifier is carried in A21. In addition, for a process in which the second device generates the second auto-negotiation page, refer to the process in which the first device generates the first auto-negotiation page in the foregoing step 2021. Details are not described herein again. After generating the second auto-negotiation page, the second device may send the second auto-negotiation page to the first device. For example, the second device sends the second auto-negotiation page to the first device via the SPE.

Step 2024: The first device receives the second auto-negotiation page sent by the second device.

After the second device sends the second auto-negotiation page, the first device correspondingly receives the second auto-negotiation page. When the second device sends the second auto-negotiation page via the SPE, the first device also receives the second auto-negotiation page via the SPE.

It should be understood that, in the foregoing step 2021 to step 2024, it only needs to be ensured that step 2022 is performed after step 2021, and step 2024 is performed after step 2023. An execution sequence of other steps is not limited. For example, because the SPE auto negotiation mechanism uses the half-duplex mode, step 2021 of sending the first auto-negotiation page may be performed before step 2023 of sending the second auto-negotiation page, or step 2023 of sending the second auto-negotiation page may be performed before step 2021 of sending the first auto-negotiation page.

For example, when only one of the first device and the second device can request to perform FEC bypass, the device that can request to perform FEC bypass may first generate and send an auto-negotiation page, and after receiving the auto-negotiation page, the other device that cannot request to perform FEC bypass triggers generation and sending of an auto-negotiation page. For example, if the first device can request to perform FEC bypass, and the second device cannot request to perform FEC bypass, the first device first performs step 2021, to generate and send the first auto-negotiation page to the second device. After receiving the first auto-negotiation page by performing step 2022, the second device triggers execution of step 2023, to generate and send the second auto-negotiation page to the first device, so that the first device continues to perform step 2024.

Step 2025: The first device determines the current operation mode based on the first identifier, the second identifier, the third identifier, the fourth identifier, the fifth identifier, and the sixth identifier.

The first device can determine, based on the first identifier, whether the first device supports the 802.3 standard, can determine, based on the second identifier, whether the first device requests FEC bypass, can determine, based on the third identifier, whether the first device supports the FEC bypass ability, can determine, based on the fourth identifier, whether the second device supports the 802.3 standard, can determine, based on the fifth identifier, whether the second device requests FEC bypass, and can determine, based on the sixth identifier, whether the second device supports the FEC bypass ability. In this way, the first device may determine a case met by the capabilities of the first device and the second device, to determine, based on the foregoing Implementation 1, that the current operation mode indicates to perform FEC bypass, or determine, based on the foregoing Implementation 2, that the current operation mode indicates not to perform FEC bypass.

Step 2026: The second device determines the current operation mode based on the first identifier, the second identifier, the third identifier, the fourth identifier, the fifth identifier, and the sixth identifier.

For a manner in which the second device determines the current operation mode based on the identifiers, refer to the manner in which the first device determines the current operation mode based on the identifiers described in the foregoing step 2025. Details are not described herein again.

An execution sequence of step 2025 and step 2026 is not limited in this embodiment of this application. For example, step 2025 may be performed before step 2026, step 2026 may be performed before step 2025, or step 2025 and step 2026 may be simultaneously performed.

For example, in this embodiment of this application, FEC may be performed by default, to provide an SNR margin and ensure robustness of data transmission. For example, in this embodiment of this application, by default, for the first device and the second device, A8 is 1 (indicating that the 802.3 standard is supported), A20 is 0 (indicating that FEC bypass is not requested), and A21 is 0 (indicating that the FEC bypass ability is not supported). In this case, the current operation mode obtained through negotiation between the first device and the second device in step 2021 to step 2026 indicates to perform FEC. Alternatively, FEC may not be performed by default, in other words, FEC bypass is performed. Details are not described herein by using an example.

It is clear that, in this embodiment of this application, a default configuration may alternatively be modified based on an actual requirement. For example, the default configuration is performing FEC and needs to be modified to performing FEC bypass. Auto negotiation control (auto negotiation control) may be performed through a management data input/output (management data input/output, MDIO) interface, to modify A20 for the first device or the second device from 0 to 1, and modify A21 for both the first device and the second device from 0 to 1. In this case, the current operation mode obtained through negotiation between the first device and the second device in step 2021 to step 2026 no longer indicates to perform FEC, but indicates to perform FEC bypass.

After the current operation mode is obtained through negotiation between the first device and the second device in the foregoing step 2021 to step 2026, the first device can process the first data based on the current operation mode, to obtain the second data. Then, for the two cases in which the current operation mode indicates to perform FEC bypass and the current operation mode indicates not to perform FEC bypass, processes in which the first device processes the first data based on the current operation mode, to obtain the second data are separately described.

Case 1: When the current operation mode indicates to perform FEC bypass, that the first device processes the first data based on the current operation mode, to obtain the second data includes: The first device processes the first data in a manner of performing FEC bypass corresponding to the current operation mode, to obtain the second data. Manners of performing FEC bypass include but are not limited to the following three manners.

Manner 1 of performing FEC bypass: The first device performs the FEC encoding operation, but the second device does not perform the FEC decoding operation. In this case, that the first device processes the first data in the manner of performing FEC bypass corresponding to the current operation mode, to obtain the second data includes: The first device performs codeword conversion and aggregation on the first data, to obtain a first result; performs FEC encoding on the first result, to obtain a second result, where the second result includes the first result and a first sequence; and performs scrambling and symbol mapping on the second result, to obtain the second data.

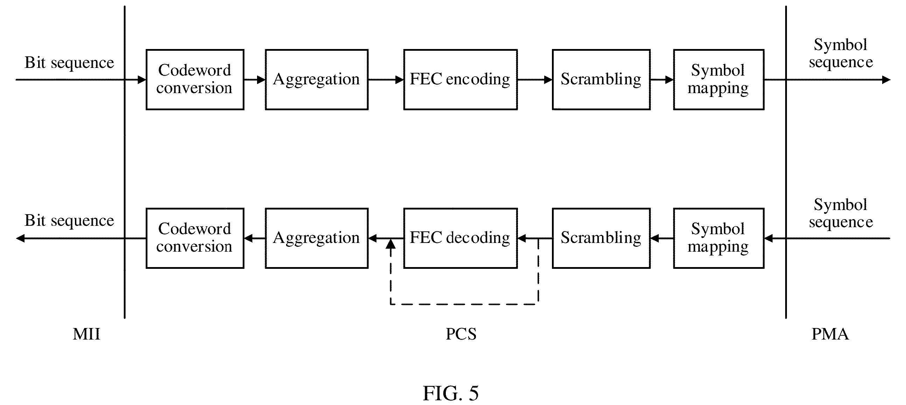

Refer to FIG. 5. A physical coding sublayer (physical coding sublayer, PCS) in the PHY chip included in the first device may sequentially perform codeword conversion, aggregation, FEC encoding, scrambling, and symbol mapping on the first data (which is a bit sequence), to obtain the second data (which is a symbol sequence).

It can be learned from the foregoing descriptions that there are a plurality of FEC code types corresponding to the FEC encoding operation and the FEC decoding operation, and the plurality of FEC code types may be classified into two types: a first-type code type and a second-type code type.

When the FEC encoding operation is performed on original data based on the first-type code type, obtained encoded data includes the original data and a check sequence, and the original data and the check sequence each occupy a part of bits in the encoded data. The bit occupied by the check sequence is a fixed part of bits in the encoded data, for example, last 36 bits in the encoded data. For example, an RS code belongs to the first-type code type. When the FEC encoding operation is performed on the original data based on the RS code type, a zero is first added after the original data to obtain zero-added data, and then the zero-added data is represented as a first polynomial. Then, the first polynomial is divided by a reference polynomial to obtain a remainder, and the previously added zero is replaced with the remainder, where the remainder is the check sequence. In this way, the encoded data including the original data and the check sequence is obtained. For example, the original data is 0000, the check sequence is 1111, and the obtained encoded data is 00001111. The check sequence may be used to correct a bit error in the original data in a subsequent FEC decoding operation process. However, because the bit occupied by the check sequence is a fixed part of bits in the encoded data, even if the FEC decoding operation is not performed, the original data may alternatively be obtained by deleting the check sequence from the encoded data.

When the FEC encoding operation is performed on original data based on the second-type code type, obtained encoded data includes updated original data. For example, a TCM code belongs to the second-type code type. For example, if the original data is still 0000, the obtained encoded data may be 10101. In this case, the FEC decoding operation needs to be performed subsequently, to restore the updated original data to the original data.

Based on the foregoing descriptions, because in Manner 1 of performing FEC bypass, the first device performs the FEC encoding operation, but the second device does not perform the FEC decoding operation, the first-type code type is used. Therefore, after the first result (namely, the original data) is obtained through codeword conversion and aggregation, FEC encoding is performed on the first result, to obtain the second result (namely, the encoded data). The second result includes the first result and the first sequence (namely, the check sequence), and the first sequence occupies a fixed part of bits in the second result.

For example, the MAC layer sends the first data to the PCS through the MII interface, and a bit rate of the first data is 100 Mbps. The PCS accumulates 10 bytes (bytes) to form an 80-bit code block, and converts the 80-bit code block into an 81-bit block through 80B/81B codeword conversion. Then, the PCS aggregates five 81-bit code blocks, and adds a 9-bit OAM field, to obtain the first result on which FEC encoding needs to be performed. A length of the first result is 5*81 bits+9 bits, that is, 414 bits.

Then, the PCS selects an RS code as the FEC code type, for example, RS-FEC (50, 46, 2⁹). For this code type, a coding gain is 3.5 decibels (decibels, dBs), a length in which correction can be performed is 0.16 microseconds, a latency is 4.3 microseconds, and a length of the second result obtained after FEC encoding is completed is 414+(50-46)*9 bits, that is, 450 bits. A length of the first sequence is 36 bits.

Then, the PCS performs scrambling on the second result, to obtain a scrambled bit sequence. A polynomial used in a scrambling process may be 1+x⁴+x¹⁵ (correspondingly, a polynomial for descrambling may be 1+x¹¹+x¹⁵). This is not limited herein. The PCS performs 3 binary 2 ternary (3 binary 2 ternary, 3B2T) PAM3 symbol mapping on the scrambled bit sequence. In this case, the 450-bit scrambled bit sequence is mapped into 450/3*2=300 PAM3 symbols, where the second data is the 300 PAM3 symbols, and a corresponding symbol rate is 75 mega bauds (mega bauds, MBd).

Manner 2 of performing FEC bypass: The first device does not perform the FEC encoding operation, and the second device does not perform the FEC decoding operation. For example, that the first device processes the first data in the manner of performing FEC bypass corresponding to the current operation mode, to obtain the second data includes: The first device performs codeword conversion, aggregation, second sequence padding, scrambling, and symbol mapping on the first data, to obtain the second data.

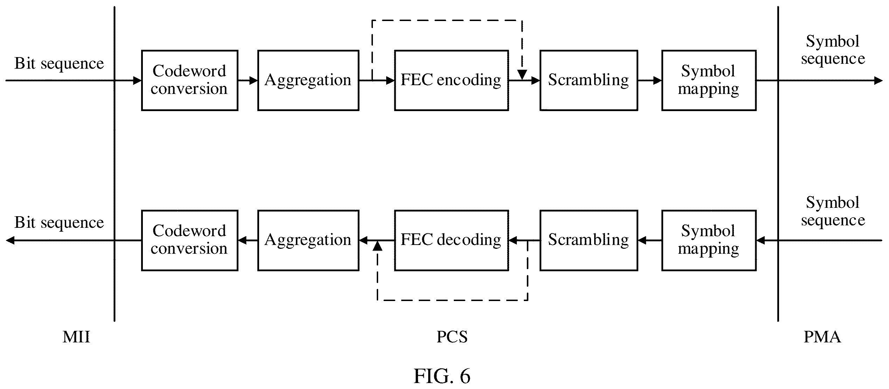

Refer to FIG. 6. A PCS in the PHY chip included in the first device may sequentially perform codeword conversion, aggregation, second sequence padding (FEC encoding is not performed), scrambling, and symbol mapping on the first data, to obtain the second data.

A second sequence for padding may be a bit sequence with a fixed length, for example, an all-zero sequence. This is not limited herein. If padding is not performed with the second sequence, because the FEC encoding operation is not performed, a quantity of bits on which scrambling needs to be performed is reduced. In this case, after scrambling and symbol mapping are performed, the obtained second data includes a small quantity of symbols. Consequently, a symbol rate in a subsequent transmission process is changed, and a transmission failure may be caused. Therefore, padding needs to be performed with the second sequence, to avoid a change of the symbol rate and ensure a transmission success rate.

Manner 3 of performing FEC bypass: The first device does not perform the FEC encoding operation, and does not perform at least one executable process corresponding to the first device. The second device does not perform the FEC decoding operation, and does not perform at least one executable process corresponding to the second device. For example, that the first device processes the first data in the manner of performing FEC bypass corresponding to the current operation mode, to obtain the second data may include: The first device performs third sequence padding, scrambling, and symbol mapping on the first data, to obtain the second data.

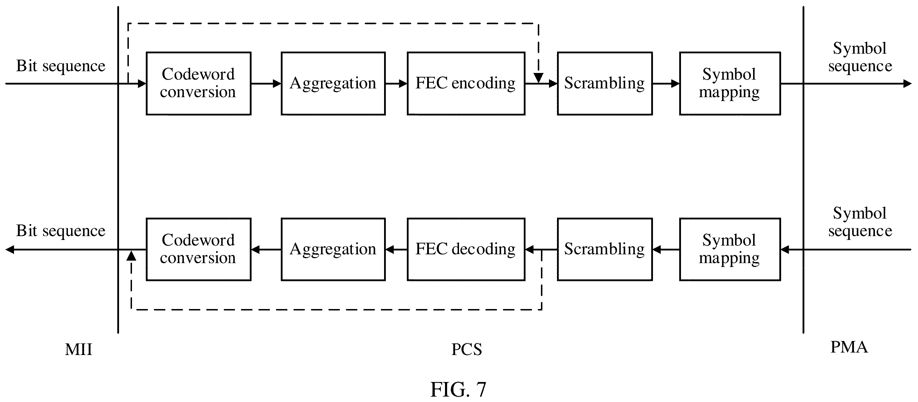

Refer to FIG. 7. A PCS in the PHY chip included in the first device may sequentially perform third sequence padding (codeword conversion, aggregation, and FEC encoding are not performed), scrambling, and symbol mapping on the first data, to obtain the second data. A reason for performing padding with a third sequence and a reason for performing padding with a second sequence are the same, and both are to avoid a change of a symbol rate and ensure a transmission success rate. Details are not described herein again.

In this embodiment of this application, the manner of performing FEC bypass corresponding to the current operation mode may be determined based on the FEC code type. For example, one manner may be determined from the foregoing three manners based on the FEC code type. For example, a process of determining, based on the FEC code type, the manner of performing FEC bypass may be performed by the first device, the second device, or the third device, or may be manually performed. This is not limited herein. The FEC code type affects a latency, a signal-to-noise ratio gain, and the like in a process of data transmission between the first device and the second device. In this case, the manner of performing FEC bypass is determined based on the FEC code type, and then the first device processes the first data in the manner of performing FEC bypass to obtain the second data. In this way, in a process in which the first device sends the second data to the second device, a latency requirement, a signal-to-noise ratio gain requirement, and the like can be met.

In addition, the manner of performing FEC bypass corresponding to the current operation mode may alternatively be obtained through negotiation between the first device and the second device. For example, for a process of obtaining the manner of performing FEC bypass through negotiation between the first device and the second device, refer to the process of obtaining the current operation mode through negotiation between the first device and the second device. For example, the technology ability field in the base page carried in the first auto-negotiation page sent by the first device to the second device not only includes the first identifier, the second identifier, and the third identifier, but may also include a seventh identifier. The seventh identifier indicates a manner of performing FEC bypass and supported by the first device. Correspondingly, the technology ability field in the base page carried in the second auto-negotiation page sent by the second device to the first device not only includes the fourth identifier, the fifth identifier, and the sixth identifier, but may also include an eighth identifier. The eighth identifier indicates a manner of performing FEC bypass and supported by the second device. Therefore, both the first device and the second device may determine the manner of performing FEC bypass and supported by the first device and the manner of performing FEC bypass and supported by the second device, so that a same manner of performing FEC bypass and supported by both the first device and the second device may be determined as the manner of performing FEC bypass corresponding to the current operation mode.

Case 2: When the current operation mode indicates not to perform FEC bypass, that the first device processes the first data based on the current operation mode, to obtain the second data includes: The first device performs codeword conversion, aggregation, FEC encoding, scrambling, and symbol mapping on the first data, to obtain the second data.

For example, refer to black solid lines in FIG. 5 to FIG. 7, a PCS in the PHY chip included in the first device sequentially performs codeword conversion, aggregation, FEC encoding, scrambling, and symbol mapping on the first data, to obtain the second data.

Case 2 is a manner of not performing FEC bypass. In the manner of not performing FEC bypass, the first device performs the FEC encoding operation, and subsequently, the second device correspondingly performs the FEC decoding operation. Because the second device performs the FEC decoding operation in Case 2, in comparison with Manner 1 of performing FEC bypass, the first device in Case 2 may not only perform the FEC encoding operation based on a first-type code type, but also perform the FEC encoding operation based on a second-type code type.

It can be learned that, regardless of whether the current operation mode indicates to perform FEC bypass or indicates not to perform FEC bypass, the first device can process the first data based on the current operation mode to obtain the second data, to continue to perform step 203.

Step 203: The first device sends the second data to the second device.

After obtaining the second data, the first device may send the second data to the second device. For example, refer to FIG. 5 to FIG. 7. After obtaining the second data, the PCS in the PHY chip included in the first device sends the second data to a physical medium attachment (physical medium attachment, PMA) sublayer in the PHY chip, so that the PMA sublayer sends the second data to the second device, and a symbol rate is not changed during sending.

A manner in which the first device sends the second data to the second device is not limited in this embodiment of this application. For example, that the first device sends the second data to the second device includes: The first device sends the second data to the second device via the SPE.

Step 204: The second device receives the second data sent by the first device.

Because the first device sends the second data to the second device, the second device correspondingly receives the second data sent by the first device. As shown in FIG. 5 to FIG. 7, a PMA sublayer in the PHY chip included in the second device receives the second data.

For example, when the first device sends the second data to the second device via the SPE, that the second device receives the second data sent by the first device includes: The second device receives, via the SPE, the second data sent by the first device.

Step 205: The second device processes the second data based on the current operation mode, to obtain the first data.

As described in step 202, the current operation mode indicates whether to perform FEC bypass. Therefore, for the two cases in which the current operation mode indicates to perform FEC bypass and the current operation mode indicates not to perform FEC bypass, processes in which the second device processes the second data based on the current operation mode, to obtain the first data are separately described.

Case 1: When the current operation mode indicates to perform FEC bypass, that the second device processes the second data based on the current operation mode, to obtain the first data includes: The second device processes the second data in the manner of performing FEC bypass corresponding to the current operation mode, to obtain the first data. The manners of performing FEC bypass include but are not limited to the following three manners.

Manner 1 of performing FEC bypass: The first device performs the FEC encoding operation, but the second device does not perform the FEC decoding operation. That the second device processes the second data in the manner of performing FEC bypass corresponding to the current operation mode, to obtain the first data includes: The second device performs symbol demapping and descrambling on the second data, to obtain the second result, where the second result includes the first result and the first sequence; discards the first sequence included in the second result, to obtain the first result; and performs separation and codeword conversion on the first result, to obtain the first data.

Refer to FIG. 5. For the second data obtained from the PMA, the PCS in the PHY chip included in the second device may sequentially perform symbol demapping, descrambling, first sequence discarding (FEC decoding is not performed), separation, and codeword conversion on the second data, to obtain the first data.

The second result is obtained through symbol demapping and descrambling. Because the second result includes the first result and the first sequence, and the first sequence occupies the fixed part of bits in the second result, the second device can determine the first sequence from the second result. Then, the second device may discard the first sequence to obtain the first result. For example, when the second result is 450 bits and the first sequence is 36 bits, the second device may discard the 36-bit first sequence, to obtain a 414-bit first result. Then, separation and codeword conversion are performed on the first result to obtain the first data.

Manner 2 of performing FEC bypass: The first device does not perform the FEC encoding operation, and the second device does not perform the FEC decoding operation. Correspondingly, that the second device processes the second data in the manner of performing FEC bypass corresponding to the current operation mode, to obtain the first data includes: The second device performs symbol demapping, descrambling, discarding of a second sequence that has been used for padding, separation, and codeword conversion on the second data, to obtain the first data.

Refer to FIG. 6. After receiving the second data sent by the PMA, the PCS in the PHY chip included in the second device sequentially performs symbol demapping, descrambling, discarding of the second sequence that has been used for padding (FEC decoding is not performed), separation, and codeword conversion on the second data, to obtain the first data.

It can be learned from the descriptions in the foregoing step 202 that the first device performs padding with the second sequence to avoid the change of the symbol rate, and the second sequence for padding does not have an actual meaning. Therefore, after obtaining a descrambling result through symbol demapping and descrambling, the second device may discard the second sequence with which the descrambling result has been padded, and then perform separation and codeword conversion, to obtain the first data.

Manner 3 of performing FEC bypass: The first device does not perform the FEC encoding operation, and does not perform at least one executable process corresponding to the first device. The second device does not perform the FEC decoding operation, and does not perform at least one executable process corresponding to the second device. For example, that the second device processes the second data in the manner of performing FEC bypass corresponding to the current operation mode, to obtain the first data includes: The second device performs, on the second data, symbol demapping, descrambling, and discarding of a third sequence that has been used for padding, to obtain the first data.

Refer to FIG. 7. The PCS in the PHY chip included in the second device receives the second data, and sequentially performs, on the second data, symbol demapping, descrambling, and discarding of the third sequence that has been used for padding (FEC decoding, separation, and codeword conversion are not performed), to obtain the first data. A reason why the second device discards the third sequence that has been used for padding and a reason why the second device discards the second sequence are the same. Details are not described herein again.

Case 2: When the current operation mode indicates not to perform FEC bypass, the first device normally performs the FEC encoding operation, and the second device also normally performs the FEC decoding operation. For example, that the second device processes the second data based on the current operation mode, to obtain the first data includes: The second device performs symbol demapping, descrambling, FEC decoding, separation, and codeword conversion on the second data, to obtain the first data.

Refer to the black solid lines in FIG. 5 to FIG. 7, the PCS in the PHY chip included in the second device sequentially performs symbol demapping, descrambling, FEC decoding, separation, and codeword conversion on the second data, to obtain the first data.

A process of physical layer data transmission between the first device and the second device is described in the foregoing step 201 to step 205. It should be understood that step 201 to step 205 are described by using an example in which the first device is a data transmitting end and the second device is a data receiving end. In addition, in this embodiment of this application, the second device may be a data transmitting end, and the first device may be a data receiving end. In this case, the second device is configured to perform actions performed by the first device in step 201 to step 203, and the first device is configured to perform actions performed by the second device in step 204 and step 205. Details are not described herein again.

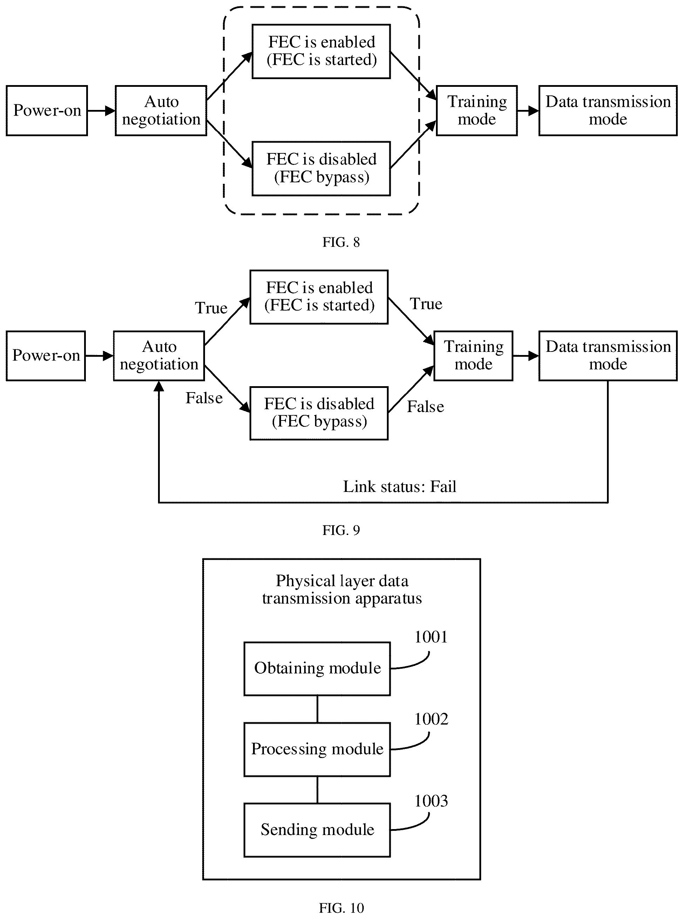

For example, refer to FIG. 8. The first device and the second device may automatically enter an auto-negotiation mode after being supplied with power (also referred to as powered on). In the auto-negotiation mode, step 2021 to step 2026 are performed to obtain the current operation mode. The current operation mode indicates not to perform FEC bypass (that is, FEC is enabled or FEC is started), or indicates to perform FEC bypass (that is, FEC is disabled). For example, in the auto-negotiation mode, the first device may further negotiate with the second device to obtain a physical layer transmission rate, a duplex mode, and the like. This is not limited herein.

After obtaining the current operation mode, the first device and the second device enter a training mode (training mode). In the training mode, the first device and the second device perform training processes such as clock synchronization, symbol synchronization, amplifier gain adjustment, and filter coefficient convergence of channel equalization and echo cancellation. This is not limited herein. After training is completed, the training mode is ended, and a data transmission mode (data mode) is entered, so that data transmission may be performed in the data transmission mode based on the current operation mode. That is, step 201 to step 205 are performed.

In addition, in a transmission process of the second data between the first device and the second device, transmission quality of the second data may be poor. For example, a default configuration of the first device and the second device is to perform FEC bypass, but a scenario is the long-distance scenario. In this case, an SNR is insufficient and a bit error rate is high because FEC bypass is incorrectly performed. Consequently, the transmission quality of the second data is poor, and even communication fails. In this case, refer to FIG. 9. In this embodiment of this application, after it is detected that the transmission quality of the second data is poor, a link status (link status) may be set to fail (fail) in the first device and the second device, and the mode returns to the auto-negotiation mode from the data transmission mode again.

After returning to the auto-negotiation mode again, the capability of the first device and the capability of the second device are updated, so that an indication of a negotiated current operation mode changes, for example, from indicating to perform FEC bypass to indicating not to perform FEC bypass. Therefore, after auto negotiation is performed again, the first device and the second device correctly use the FEC to perform data transmission, to improve data transmission quality.

In conclusion, in this embodiment of this application, in the physical layer data transmission process, whether to perform FEC bypass may be properly determined based on the current operation mode. In this way, a requirement of using the FEC in the long-distance data transmission scenario can be supported, and a requirement of not using the FEC in the low-latency data transmission scenario can be supported, to ensure reliability of data transmission in different scenarios.

The foregoing describes the physical layer data transmission method provided in embodiments of this application. Corresponding to the foregoing method, an embodiment of this application further provides a physical layer data transmission apparatus. The apparatus is used in a first device. The apparatus is configured to perform, by using modules shown in FIG. 10, the steps performed by the first device in FIG. 2. As shown in FIG. 10, the apparatus includes the following modules:
an obtaining module 1001, configured to obtain first data;
a processing module 1002, configured to process the first data based on a current operation mode, to obtain second data, where the current operation mode indicates whether to perform FEC bypass, and the current operation mode is determined based on capabilities of the first device and a second device; and
a sending module 1003, configured to send the second data to the second device.

In an example embodiment, the sending module 1003 is configured to send the second data to the second device via an SPE.

In an example embodiment, the processing module 1002 is configured to: when the current operation mode indicates to perform FEC bypass, process the first data in a manner of performing FEC bypass corresponding to the current operation mode, to obtain the second data. The manner of performing FEC bypass is determined based on an FEC code type.

In an example embodiment, performing FEC bypass includes at least one of the following: The first device does not perform an FEC encoding operation; and the second device does not perform an FEC decoding operation.

In an example embodiment, the current operation mode indicates to perform FEC bypass if the capabilities of the first device and the second device meet the following cases: Both the first device and the second device support an 802.3 standard; both the first device and the second device support an FEC bypass ability; and at least one of the first device and the second device requests FEC bypass.

In an example embodiment, the current operation mode indicates not to perform FEC bypass if the capabilities of the first device and the second device meet at least one of the following cases: At least one of the first device and the second device does not support an 802.3 standard; at least one of the first device and the second device does not support an FEC bypass ability; and neither the first device nor the second device request FEC bypass.

In an example embodiment, the apparatus further includes: a negotiation module, configured to: exchange auto-negotiation pages with the second device, and determine the current operation mode based on technology ability fields in base pages carried in the auto-negotiation pages.

In an example embodiment, the negotiation module is configured to: generate a first auto-negotiation page, and send the first auto-negotiation page to the second device, where the first auto-negotiation page carries the base page, the technology ability field in the base page includes a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability; receive a second auto-negotiation page sent by the second device, where the second auto-negotiation page carries the base page, the technology ability field in the base page includes a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and determine the current operation mode based on the first identifier, the second identifier, the third identifier, the fourth identifier, the fifth identifier, and the sixth identifier.

In an example embodiment, the processing module 1002 is configured to: when the current operation mode indicates not to perform FEC bypass, perform codeword conversion, aggregation, FEC encoding, scrambling, and symbol mapping on the first data, to obtain the second data.

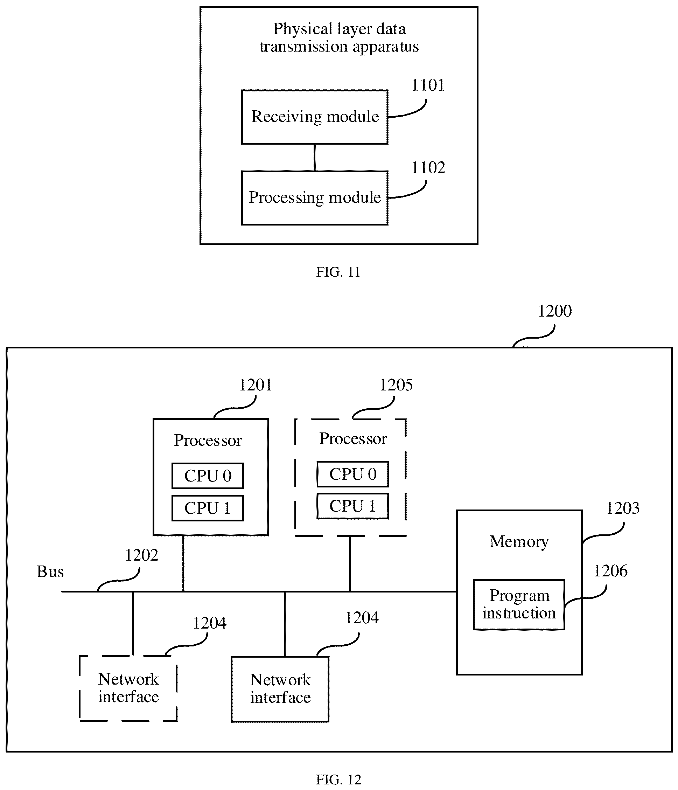

An embodiment of this application further provides another physical layer data transmission apparatus. The apparatus is used in a second device. The apparatus is configured to perform, by using modules shown in FIG. 11, the steps performed by the second device in FIG. 2. As shown in FIG. 11, the apparatus includes the following modules:
a receiving module 1101, configured to receive second data sent by a first device; and
a processing module 1102, configured to process the second data based on a current operation mode, to obtain first data, where the current operation mode indicates whether to perform FEC bypass, and the current operation mode is determined based on capabilities of the first device and the second device.

In an example embodiment, the receiving module 1101 is configured to receive, via an SPE, the second data sent by the first device.

In an example embodiment, the processing module 1102 is configured to: when the current operation mode indicates to perform FEC bypass, process the second data in a manner of performing FEC bypass corresponding to the current operation mode, to obtain the first data. The manner of performing FEC bypass is determined based on an FEC code type.

In an example embodiment, performing FEC bypass includes at least one of the following: The first device does not perform an FEC encoding operation; and the second device does not perform an FEC decoding operation.

In an example embodiment, the current operation mode indicates to perform FEC bypass if the capabilities of the first device and the second device meet the following cases: Both the first device and the second device support an 802.3 standard; both the first device and the second device support an FEC bypass ability; and at least one of the first device and the second device requests FEC bypass.

In an example embodiment, the current operation mode indicates not to perform FEC bypass if the capabilities of the first device and the second device meet at least one of the following cases: At least one of the first device and the second device does not support an 802.3 standard; at least one of the first device and the second device does not support an FEC bypass ability; and neither the first device nor the second device request FEC bypass.

In an example embodiment, the apparatus further includes: a negotiation module, configured to: exchange auto-negotiation pages with the first device, and determine the current operation mode based on technology ability fields in base pages carried in the auto-negotiation pages.

In an example embodiment, the negotiation module is configured to: receive a first auto-negotiation page sent by the first device, where the first auto-negotiation page carries the base page, the technology ability field in the base page includes a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability; generate a second auto-negotiation page, and send the second auto-negotiation page to the first device, where the second auto-negotiation page carries the base page, the technology ability field in the base page includes a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and determine the current operation mode based on the first identifier, the second identifier, the third identifier, the fourth identifier, the fifth identifier, and the sixth identifier.

In an example embodiment, the processing module 1102 is configured to: when the current operation mode indicates not to perform FEC bypass, perform symbol demapping, descrambling, FEC decoding, separation, and codeword conversion on the second data, to obtain the first data.

It should be understood that, when the apparatuses shown in FIG. 10 and FIG. 11 implement functions of the apparatuses, beneficial effects of the apparatuses are the same as the those of the method shown in FIG. 2. Details are not described herein again. In addition, when the apparatuses shown in FIG. 10 and FIG. 11 implement the functions of the apparatuses, division into the foregoing functional modules is merely used as an example for description. In actual application, the foregoing functions may be allocated to different functional modules for implementation based on a requirement. In other words, an internal structure of a device is divided into different functional modules, to implement all or some of the functions described above. In addition, the apparatuses provided in the foregoing embodiments and method embodiments pertain to a same concept. For specific implementation processes of the apparatuses, refer to method embodiments. Details are not described herein again.

An embodiment of this application further provides a physical layer data transmission device. The device includes a memory and a processor. The memory stores at least one instruction, and the at least one instruction is loaded and executed by the processor, to cause the device to perform the physical layer data transmission method shown in FIG. 2.

FIG. 12 is a diagram of a structure of an example of a physical layer data transmission device 1200 according to this application. The physical layer data transmission device 1200 includes at least one processor 1201, a memory 1203, and at least one network interface 1204.

The processor 1201 is, for example, a general-purpose central processing unit (central processing unit, CPU), a digital signal processor (digital signal processor, DSP), a network processor (network processor, NP), a GPU, a neural-network processing unit (neural-network processing unit, NPU), a data processing unit (data processing unit, DPU), a microprocessor, one or more integrated circuits or application-specific integrated circuits (application-specific integrated circuits, ASICs) configured to implement the solutions of this application, a programmable logic device (programmable logic device, PLD), another general-purpose processor or another programmable logic device, a discrete gate, a transistor logic device, a discrete hardware component, or any combination thereof. The PLD is, for example, a complex programmable logic device (complex programmable logic device, CPLD), a field-programmable logic gate array (field-programmable gate array, FPGA), generic array logic (generic array logic, GAL), or any combination thereof. The general-purpose processor may be a microprocessor, any conventional processor, or the like. It should be noted that the processor may be a processor that supports an advanced reduced instruction set computing machines (advanced RISC machines, ARM) architecture. The processor may implement or execute various logical blocks, modules, and circuits described with reference to content disclosed in this application. Alternatively, the processor may be a combination of processors implementing a computing function, for example, a combination including one or more microprocessors, or a combination of a DSP and a microprocessor.

Optionally, the physical layer data transmission device 1200 further includes a bus 1202. The bus 1202 is configured to transfer information between components of the physical layer data transmission device 1200. The bus 1202 may be a peripheral component interconnect standard (peripheral component interconnect, PCI for short) bus, an extended industry standard architecture (extended industry standard architecture, EISA for short) bus, or the like. The bus 1202 may be classified into an address bus, a data bus, a control bus, and the like. For ease of representation, only one line is used in FIG. 12 for representation, but it does not indicate that there is only one bus or only one type of bus.

The memory 1203 is, for example, a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) and is used as an external cache.

By way of an example but not limitative descriptions, many forms of ROMs and RAMs are available. For example, the ROM is a compact disc read-only memory (compact disc read-only memory, CD-ROM). The RAM includes but is not limited to a static random access memory (static RAM, SRAM), a dynamic random access memory (dynamic random access memory, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The memory 1203 may alternatively be another type of storage device that can store static information and instructions. Alternatively, the memory 1203 may be another type of dynamic storage device that can store information and instructions. Alternatively, the memory 1203 may be other compact disc storage, optical disc storage (including a compact disc, a laser disc, an optical disc, a digital versatile disc, a Blu-ray disc, and the like), a magnetic disk storage medium, another magnetic storage device, or any other medium that can be used to carry or store expected program code in a form of instructions or a data structure and that can be accessed by a computer. However, the memory 1203 is not limited thereto. For example, the memory 1203 exists independently, and is connected to the processor 1201 through the bus 1202. Alternatively, the memory 1203 may be integrated with the processor 1201.

The network interface 1204 is configured to communicate with another device or a communication network by using an apparatus of any transceiver type. The communication network may be an Ethernet, a radio access network (radio access network, RAN), a wireless local area network (wireless local area network, WLAN), or the like. The network interface 1204 may include a wired network interface, and may further include a wireless network interface. Specifically, the network interface 1204 may be an Ethernet (Ethernet) interface, for example, a fast Ethernet (Fast Ethernet, FE) interface, a gigabit Ethernet (Gigabit Ethernet, GE) interface, an asynchronous transfer mode (Asynchronous Transfer Mode, ATM) interface, a WLAN interface, a cellular network interface, or a combination thereof. The Ethernet interface may be an optical interface, an electrical interface, or a combination thereof. In some implementations of this application, the network interface 1204 may be used by the physical layer data transmission device 1200 to communicate with another device.

In a specific implementation, in some implementations, the processor 1201 may include one or more CPUs, for example, a CPU 0 and a CPU 1 shown in FIG. 12. Each of the processors may be a single-core processor, or may be a multi-core processor. The processor herein may be one or more devices, circuits, and/or processing cores configured to process data (for example, computer program instructions).

In a specific implementation, in some implementations, the physical layer data transmission device 1200 may include a plurality of processors, for example, the processor 1201 and a processor 1205 shown in FIG. 12. Each of the processors may be a single-core processor, or may be a multi-core processor. The processor herein may be one or more devices, circuits, and/or processing cores configured to process data (for example, computer program instructions).

In some implementations, the memory 1203 is configured to store program instructions 1206 for executing the solutions of this application, and the processor 1201 may execute the program instructions 1206 stored in the memory 1203. In other words, the physical layer data transmission device 1200 may implement, by using the processor 1201 and the program instructions 1206 in the memory 1203, the method provided in method embodiments, that is, the method shown in FIG. 2. The program instructions 1206 may include one or more software modules. Optionally, the processor 1201 may also store program instructions for executing the solutions of this application.

In a specific implementation process, the physical layer data transmission device 1200 in this application may correspond to the first device or the second device configured to perform the foregoing method. The processor 1201 in the physical layer data transmission device 1200 reads the instructions in the memory 1203, to cause the physical layer data transmission device 1200 shown in FIG. 12 to perform all or some of the steps in method embodiments.

The physical layer data transmission device 1200 may further correspond to the apparatus shown in FIG. 10 or FIG. 11. Each functional module in the apparatus shown in FIG. 10 or FIG. 11 is implemented by using software of the physical layer data transmission device 1200. In other words, the functional modules included in the apparatus shown in FIG. 10 or FIG. 11 are generated after the processor 1201 of the physical layer data transmission device 1200 reads the program instructions 1206 stored in the memory 1203.

The steps in the method shown in FIG. 2 are completed by using an integrated logic circuit of hardware in the processor of the physical layer data transmission device 1200, or by using instructions in a form of software. The steps in method embodiments disclosed with reference to this application may be directly performed and completed by a hardware processor, or may be performed and completed by using a combination of hardware in the processor and a software module. The software module may be located in a mature storage medium in the art, for example, a random access memory, a flash memory, a read-only memory, a programmable read-only memory, an electrically erasable programmable memory, or a register. The storage medium is located in the memory, and the processor reads information in the memory, and completes the steps in the foregoing method embodiments in combination with hardware of the processor. To avoid repetition, details are not described herein again.

In an example embodiment, a physical layer data transmission system is provided. The system includes a first device and a second device. The first device is configured to perform steps performed by the first device in the physical layer data transmission method shown in FIG. 2. The second device is configured to perform steps performed by the second device in the physical layer data transmission method shown in FIG. 2.

For example, a chip is provided. The chip includes a processor, and the processor is configured to: invoke instructions stored in a memory, and run the instructions, to cause a computer in which the chip is installed to perform the physical layer data transmission method shown in FIG. 2.

In an example embodiment, another chip is provided, including an input interface, an output interface, a processor, and a memory. The input interface, the output interface, the processor, and the memory are connected through an internal connection path. The processor is configured to execute code in the memory, and when the code is executed, a computer in which the chip is installed performs the physical layer data transmission method shown in FIG. 2.

In an example embodiment, a computer program (product) is provided. The computer program (product) includes computer program code, and when the computer program code is run by a computer, the computer is caused to perform the physical layer data transmission method shown in FIG. 2.

For example, a computer-readable storage medium is provided. The computer-readable storage medium stores a program or instructions, and when the program or the instructions are run on a computer, the physical layer data transmission method shown in FIG. 2 is performed.

All or some of the foregoing embodiments may be implemented by using software, hardware, firmware, or any combination thereof. When software is used to implement embodiments, all or some of embodiments may be implemented in a form of a computer program product. The computer program product includes one or more computer instructions. When the computer program instructions are loaded and executed on the computer, the procedure or functions according to this application are all or partially generated. The computer may be a general-purpose computer, a dedicated computer, a computer network, or another programmable apparatus. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk)), or the like.

In this application, terms such as "first" and "second" are used to distinguish between same items or similar items that have basically same effects and functions. It should be understood that there is no logical or time sequence dependency between "first", "second", and "nth", and a quantity and an execution sequence are not limited. It should be further understood that although the following descriptions use terms such as "first" and "second" to describe various elements, these elements should not be limited by the terms. These terms are merely used to distinguish one element from another element. It should be further understood that sequence numbers of processes do not mean execution sequences in various embodiments of this application. The execution sequences of the processes should be determined based on functions and internal logic of the processes, and should not be construed as any limitation on the implementation processes of embodiments of this application.

The term "at least one" in this application means one or more, and the term "a plurality of" in this application means two or more. For example, a plurality of bits means two or more bits. The terms "system" and "network" are often used interchangeably in this specification. It should be understood that the terms used in the descriptions of the various examples in this specification are merely intended to describe specific examples, and are not intended to impose a limitation. The terms "one" ("a" and "an") and "the" of singular forms used in the descriptions of the various examples and the appended claims are also intended to include plural forms, unless otherwise specified in the context clearly.

It should be further understood that the term "and/or" used in this specification indicates and includes any combination or all possible combinations of one or more of the associated listed items. The term "and/or" describes an association relationship between associated objects and indicates that three relationships may exist. For example, A and/or B may indicate the following three cases: Only A exists, both A and B exist, and only B exists. In addition, the character "/" in this application usually indicates an "or" relationship between the associated objects.

It should be further understood that the terms "if" and "assuming that" may be interpreted to mean "when" ("when" or "upon") or "in response to determining" or "in response to detecting". Similarly, according to the context, the phrase "if it is determined that" or "if [a stated condition or event] is detected" may be interpreted to mean "when it is determined that", "in response to determining", "when [the stated condition or event] is detected", or "in response to detecting [the stated condition or event]".

The foregoing descriptions are merely embodiments of this application, but are not intended to limit this application. Any modification, equivalent replacement, improvement, or the like made without departing from the principle of this application should fall within the protection scope of this application.

## Claims

1. A physical layer data transmission method, wherein the method comprises:
obtaining, by a first device, first data;
processing, by the first device, the first data based on a current operation mode, to obtain second data, wherein the current operation mode indicates whether to perform forward error correction FEC bypass, and the current operation mode is determined based on capabilities of the first device and a second device; and
sending, by the first device, the second data to the second device.

2. The method according to claim 1, wherein sending, by the first device, the second data to the second device comprises:
sending, by the first device, the second data to the second device via a single pair Ethernet SPE.

3. The method according to claim 1 or 2, wherein processing, by the first device, the first data based on the current operation mode, to obtain the second data comprises:
when the current operation mode indicates to perform FEC bypass, processing, by the first device, the first data in a manner of performing FEC bypass corresponding to the current operation mode, to obtain the second data, wherein the manner of performing FEC bypass is determined based on an FEC code type.

4. The method according to any one of claims 1 to 3, wherein the performing FEC bypass comprises at least one of the following: the first device does not perform an FEC encoding operation; and the second device does not perform an FEC decoding operation.

5. The method according to any one of claims 1 to 4, wherein the current operation mode indicates to perform FEC bypass if the capabilities of the first device and the second device meet the following cases:
both the first device and the second device support an 802.3 standard;
both the first device and the second device support an FEC bypass ability; and
at least one of the first device and the second device requests FEC bypass.

6. The method according to any one of claims 1 to 4, wherein the current operation mode indicates not to perform FEC bypass if the capabilities of the first device and the second device meet at least one of the following cases:
at least one of the first device and the second device does not support an 802.3 standard;
at least one of the first device and the second device does not support an FEC bypass ability; and
neither the first device nor the second device request FEC bypass.

7. The method according to any one of claims 1 to 6, wherein before processing, by the first device, the first data based on the current operation mode, to obtain the second data, the method further comprises:
exchanging, by the first device, auto-negotiation pages with the second device, and determining the current operation mode based on technology ability fields in base pages carried in the auto-negotiation pages.

8. The method according to claim 7, wherein exchanging, by the first device, the auto-negotiation pages with the second device, and determining the current operation mode based on the technology ability fields in the base pages carried in the auto-negotiation pages comprises:
generating, by the first device, a first auto-negotiation page, and sending the first auto-negotiation page to the second device, wherein the first auto-negotiation page carries the base page, the technology ability field in the base page comprises a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability;
receiving, by the first device, a second auto-negotiation page sent by the second device, wherein the second auto-negotiation page carries the base page, the technology ability field in the base page comprises a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and
determining, by the first device, the current operation mode based on the first identifier, the second identifier, the third identifier, the fourth identifier, the fifth identifier, and the sixth identifier.

9. The method according to any one of claims 1 to 8, wherein processing, by the first device, the first data based on the current operation mode, to obtain the second data comprises:
when the current operation mode indicates not to perform FEC bypass, performing, by the first device, codeword conversion, aggregation, FEC encoding, scrambling, and symbol mapping on the first data, to obtain the second data.

10. A physical layer data transmission method, wherein the method comprises:
receiving, by a second device, second data sent by a first device; and
processing, by the second device, the second data based on a current operation mode, to obtain first data, wherein the current operation mode indicates whether to perform forward error correction FEC bypass, and the current operation mode is determined based on capabilities of the first device and the second device.

11. The method according to claim 10, wherein receiving, by the second device, the second data sent by the first device comprises:
receiving, by the second device via a single pair Ethernet SPE, the second data sent by the first device.

12. The method according to claim 10 or **11,** wherein processing, by the second device, the second data based on the current operation mode, to obtain the first data comprises:
when the current operation mode indicates to perform FEC bypass, processing, by the second device, the second data in a manner of performing FEC bypass corresponding to the current operation mode, to obtain the first data, wherein the manner of performing FEC bypass is determined based on an FEC code type.

13. The method according to any one of claims 10 to 12, wherein performing FEC bypass comprises at least one of the following: the first device does not perform an FEC encoding operation; and the second device does not perform an FEC decoding operation.

14. The method according to any one of claims 10 to 13, wherein the current operation mode indicates to perform FEC bypass if the capabilities of the first device and the second device meet the following cases:
both the first device and the second device support an 802.3 standard;
both the first device and the second device support an FEC bypass ability; and
at least one of the first device and the second device requests FEC bypass.

15. The method according to any one of claims 10 to 13, wherein the current operation mode indicates not to perform FEC bypass if the capabilities of the first device and the second device meet at least one of the following cases:
at least one of the first device and the second device does not support an 802.3 standard;
at least one of the first device and the second device does not support an FEC bypass ability; and
neither the first device nor the second device request FEC bypass.

16. The method according to any one of claims 10 to 15, wherein before processing, by the second device, the second data based on the current operation mode, to obtain the first data, the method further comprises:
exchanging, by the second device, auto-negotiation pages with the first device, and determining the current operation mode based on technology ability fields in base pages carried in the auto-negotiation pages.

17. The method according to claim 16, wherein exchanging, by the second device, the auto-negotiation pages with the first device, and determining the current operation mode based on the technology ability fields in the base pages carried in the auto-negotiation pages comprises:
receiving, by the second device, a first auto-negotiation page sent by the first device, wherein the first auto-negotiation page carries the base page, the technology ability field in the base page comprises a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability;
generating, by the second device, a second auto-negotiation page, and sending the second auto-negotiation page to the first device, wherein the second auto-negotiation page carries the base page, the technology ability field in the base page comprises a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and
determining, by the second device, the current operation mode based on the first identifier, the second identifier, the third identifier, the fourth identifier, the fifth identifier, and the sixth identifier.

18. The method according to any one of claims 10 to 17, wherein processing, by the second device, the second data based on the current operation mode, to obtain the first data comprises:
when the current operation mode indicates not to perform FEC bypass, performing, by the second device, symbol demapping, descrambling, FEC decoding, separation, and codeword conversion on the second data, to obtain the first data.

19. A physical layer data transmission apparatus, wherein the apparatus is used in a first device, and the apparatus comprises:
an obtaining module, configured to obtain first data;
a processing module, configured to process the first data based on a current operation mode, to obtain second data, wherein the current operation mode indicates whether to perform forward error correction FEC bypass, and the current operation mode is determined based on capabilities of the first device and a second device; and
a sending module, configured to send the second data to the second device.

20. The apparatus according to claim 19, wherein the sending module is configured to send the second data to the second device via a single pair Ethernet SPE.

21. The apparatus according to claim 19 or 20, wherein the processing module is configured to: when the current operation mode indicates to perform FEC bypass, process the first data in a manner of performing FEC bypass corresponding to the current operation mode, to obtain the second data, wherein the manner of performing FEC bypass is determined based on an FEC code type.

22. The apparatus according to any one of claims 19 to 21, wherein performing FEC bypass comprises at least one of the following: the first device does not perform an FEC encoding operation; and the second device does not perform an FEC decoding operation.

23. The apparatus according to any one of claims 19 to 22, wherein the current operation mode indicates to perform FEC bypass if the capabilities of the first device and the second device meet the following cases:
both the first device and the second device support an 802.3 standard;
both the first device and the second device support an FEC bypass ability; and
at least one of the first device and the second device requests FEC bypass.

24. The apparatus according to any one of claims 19 to 22, wherein the current operation mode indicates not to perform FEC bypass if the capabilities of the first device and the second device meet at least one of the following cases:
at least one of the first device and the second device does not support an 802.3 standard;
at least one of the first device and the second device does not support an FEC bypass ability; and
neither the first device nor the second device request FEC bypass.

25. The apparatus according to any one of claims 19 to 24, wherein the apparatus further comprises:
a negotiation module, configured to: exchange auto-negotiation pages with the second device, and determine the current operation mode based on technology ability fields in base pages carried in the auto-negotiation pages.

26. The apparatus according to claim 25, wherein the negotiation module is configured to: generate a first auto-negotiation page, and send the first auto-negotiation page to the second device, wherein the first auto-negotiation page carries the base page, the technology ability field in the base page comprises a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability; receive a second auto-negotiation page sent by the second device, wherein the second auto-negotiation page carries the base page, the technology ability field in the base page comprises a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and determine the current operation mode based on the first identifier, the second identifier, the third identifier, the fourth identifier, the fifth identifier, and the sixth identifier.

27. The apparatus according to any one of claims 19 to 26, wherein the processing module is configured to: when the current operation mode indicates not to perform FEC bypass, perform codeword conversion, aggregation, FEC encoding, scrambling, and symbol mapping on the first data, to obtain the second data.

28. A physical layer data transmission apparatus, wherein the apparatus is used in a second device, and the apparatus comprises:
a receiving module, configured to receive second data sent by a first device; and
a processing module, configured to process the second data based on a current operation mode, to obtain first data, wherein the current operation mode indicates whether to perform forward error correction FEC bypass, and the current operation mode is determined based on capabilities of the first device and the second device.

29. The apparatus according to claim 28, wherein the receiving module is configured to receive, via a single pair Ethernet SPE, the second data sent by the first device.

30. The apparatus according to claim 28 or 29, wherein the processing module is configured to: when the current operation mode indicates to perform FEC bypass, process the second data in a manner of performing FEC bypass corresponding to the current operation mode, to obtain the first data, wherein the manner of performing FEC bypass is determined based on an FEC code type.

31. The apparatus according to any one of claims 28 to 30, wherein performing FEC bypass comprises at least one of the following: the first device does not perform an FEC encoding operation; and the second device does not perform an FEC decoding operation.

32. The apparatus according to any one of claims 28 to 31, wherein the current operation mode indicates to perform FEC bypass if the capabilities of the first device and the second device meet the following cases:
both the first device and the second device support an 802.3 standard;
both the first device and the second device support an FEC bypass ability; and
at least one of the first device and the second device requests FEC bypass.

33. The apparatus according to any one of claims 28 to 31, wherein the current operation mode indicates not to perform FEC bypass if the capabilities of the first device and the second device meet at least one of the following cases:
at least one of the first device and the second device does not support an 802.3 standard;
at least one of the first device and the second device does not support an FEC bypass ability; and
neither the first device nor the second device request FEC bypass.

34. The apparatus according to any one of claims 28 to 33, wherein the apparatus further comprises:
a negotiation module, configured to: exchange auto-negotiation pages with the first device, and determine the current operation mode based on technology ability fields in base pages carried in the auto-negotiation pages.

35. The apparatus according to claim 34, wherein the negotiation module is configured to: receive a first auto-negotiation page sent by the first device, wherein the first auto-negotiation page carries the base page, the technology ability field in the base page comprises a first identifier, a second identifier, and a third identifier, the first identifier indicates whether the first device supports the 802.3 standard, the second identifier indicates whether the first device requests FEC bypass, and the third identifier indicates whether the first device supports the FEC bypass ability; generate a second auto-negotiation page, and send the second auto-negotiation page to the first device, wherein the second auto-negotiation page carries the base page, the technology ability field in the base page comprises a fourth identifier, a fifth identifier, and a sixth identifier, the fourth identifier indicates whether the second device supports the 802.3 standard, the fifth identifier indicates whether the second device requests FEC bypass, and the sixth identifier indicates whether the second device supports the FEC bypass ability; and determine the current operation mode based on the first identifier, the second identifier, the third identifier, the fourth identifier, the fifth identifier, and the sixth identifier.

36. The apparatus according to any one of claims 28 to 35, wherein the processing module is configured to: when the current operation mode indicates not to perform FEC bypass, perform symbol demapping, descrambling, FEC decoding, separation, and codeword conversion on the second data, to obtain the first data.

37. A physical layer data transmission system, wherein the system comprises a first device and a second device, the first device is configured to perform the physical layer data transmission method according to any one of claims 1 to 9, and the second device is configured to perform the physical layer data transmission method according to any one of claims 10 to 18.

38. A physical layer data transmission device, wherein the device comprises a memory and a processor, wherein
the memory stores at least one instruction, and the at least one instruction is loaded and executed by the processor, to cause the device to implement the physical layer data transmission method according to any one of claims 1 to 18.

39. A chip, wherein the chip comprises a processor, and the processor is configured to: invoke instructions stored in a memory, and run the instructions, to cause a computer in which the chip is installed to perform the physical layer data transmission method according to any one of claims 1 to 18.
